(19) Europäisches Patentamt / European Patent Office / Office européen des brevets

(11) **EP 3 783 572 B1**

(12) **EUROPEAN PATENT SPECIFICATION**

(45) Date of publication and mention
of the grant of the patent:
**10.01.2024 Bulletin 2024/02**

(21) Application number: **20190383.8**

(22) Date of filing: **11.08.2020**

(51) International Patent Classification (IPC):
*G06T 17/30* (2006.01)     *G06F 30/20* (2020.01)

(52) Cooperative Patent Classification (CPC):
**G06T 17/30;** G06F 30/10; G06F 30/20

(54) **SYSTEM AND METHOD FOR DEFINING TRIMMED SPLINE SURFACES WITH ACCURATE BOUNDARY CONTROL IMPLEMENTED IN A COMPUTER SYSTEM**

SYSTEM UND VERFAHREN ZUM DEFINIEREN VON GETRIMMTEN SPLINEFLÄCHEN MIT GENAUER GRENZKONTROLLE, DIE IN EINEM COMPUTERSYSTEM IMPLEMENTIERT IST

SYSTÈME ET PROCÉDÉ PERMETTANT DE DÉFINIR DES SURFACES CANNELÉES LIMITÉES AVEC UN CONTRÔLE PRÉCIS DES LIMITES MIS EN OEUVRE DANS UN SYSTÈME INFORMATIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.08.2019 EP 19192703**

(43) Date of publication of application:
**24.02.2021 Bulletin 2021/08**

(73) Proprietor: **Technische Universität Darmstadt 64289 Darmstadt (DE)**

(72) Inventor: **Reif, Ulrich 64289 Darmstadt (DE)**

(74) Representative: **2K Patentanwälte Blasberg Kewitz & Reichel Partnerschaft mbB Schumannstrasse 27 60325 Frankfurt am Main (DE)**

(56) References cited:
**US-B1- 8 836 701**

• **VÁRADY TAMÁS ET AL: "Enhancement of a multi-sided Bézier surface representation", COMPUTER AIDED GEOMETRIC DESIGN, NORTH-HOLLAND, AMSTERDAM, NL, vol. 55, 15 May 2017 (2017-05-15), pages 69-83, XP085069869, ISSN: 0167-8396, DOI: 10.1016/J.CAGD.2017.05.002**
• **SHEN JINGJING ET AL: "Converting a CAD model into a non-uniform subdivision surface", COMPUTER AIDED GEOMETRIC DESIGN, NORTH-HOLLAND, AMSTERDAM, NL, vol. 48, 29 July 2016 (2016-07-29), pages 17-35, XP029772396, ISSN: 0167-8396, DOI: 10.1016/J.CAGD.2016.07.003**
• **BENJAMIN MARUSSIG: "Advances in the Treatment of Trimmed CAD Models due to Isogeometric Analysis", ARXIV.ORG, CORNELL UNIVERSITY LIBRARY, 201 OLIN LIBRARY CORNELL UNIVERSITY ITHACA, NY 14853, 31 January 2019 (2019-01-31), XP081019249,**

**Description**

**1 Field of the invention**

The present invention relates generally to the construction and representation of surfaces in a computer system, especially in a CAD system, by means of splines. In particular, the problem of customizing trimmed NURBS surfaces so that they conform exactly with prescribed boundary data is addressed.

**2 State of the art**

Non-uniform rational B-splines (NURBS) are the predominant tool for modeling curves and surfaces in Computer-Aided Design (CAD). Standardized file formats like NBSIR 80-1978 (IGES) or ISO 10303 (STEP) are established to exchange data between different parties in the industrial process from design to manufacturing and beyond.

A tensor product NURBS surface is a mapping from some rectangular domain in $\mathbb{R}^2$ to geometry space $\mathbb{R}^3$, where the function is composed of polynomial or rational segments. However, according to the shape of the domain, NURBS typically parametrize four-sided surface patches, what is too restrictive for many design applications. Existing modifications to gain more flexibility include T-splines [3], geometric continuity [6], subdivision [2], and various ways to construct multi-sided surface patches [5, 4].

In practice, however, the prevalent method for constructing complex freeform geometry is the use of *trimmed NURBS surfaces* [1]. This means that the originally four-sided shape is pruned by a closed loop of trimming curves, which can be specified either as planar spline curves in the parameter domain or as spatial spline curves in geometry space. While trimming itself is simple and intuitive, problems occur if a trimmed patch shall be connected with a neighboring one to form a composite surface. Considering two surfaces **s** and **s̃** with boundary curves **c** and **c̃**, respectively, the task is to achieve **c** = **c̃**. There are two options: First, if the trimming curve is specified as a planar spline curve $\gamma$ in the domain, it is **c** = **s** ∘ $\gamma$. Then, **c** is a spline curve again, but its degree is high, and its knot sequence is uneven. This makes it hard to control the shape of **c** to bring it into line with **c̃**. Second, if the boundary curve **c** is specified directly as a curve in geometry space, it is typically not part of the given surface s. Then, the trimming is done along the projection of **c** onto **s.** Hence, in this case, the actual trimming curve differs from the desired shape. It is possible to adapt the shape of **s** such that this difference becomes small, but achieving equality is a hard problem, again.

Hence, as things stand today, gaps along boundary curves in composite trimmed NURBS surfaces are to be accepted. Substantial efforts are required to control their size, and any inaccuracy may impair subsequent processes in design and manufacturing. Things become even more challenging if, in addition to a match of boundary curves, also an approximately smooth transition of normal vectors and curvature tensors shall be guaranteed. Sometimes, when demands on the surface quality are high, human interaction is requested to accomplish the task in a tedious trial-and-error process.

**3 Summary of the invention**

The invention discloses a method and a computing device to construct a trimmed spline surface a for processing in 3D-printers or CNC machines, from a given spline surface b, called the *base*, and a set of auxiliary spline surfaces $\mathbf{r}_\ell$, called *ribbons,* implemented in computer system, preferably in a CAD or CAM system. The interior shape of **a** is dominated by the base, while its shape along the boundaries is determined by the ribbons. The desired combination of base and ribbons is facilitated by specific weight functions, blending between the components, and specific reparametrizations, adapting the ribbons to the base.

So far, no general method for accurately adapting a trimmed NURBS surfaces to user-given boundary data is known. Despite a partial formal analogy, the method described in [4] is different because

  1. its general purpose is to smoothly fill a network of curves or ribbons by rational surface patches, and not trimming;
  2. it does not work with a base surface to be trimmed, but only with ribbons to build a multi-sided surface patch from scratch;
  3. it does not deal with splines, but polynomial ribbons only;
  4. it uses only implicit representations $q_\ell$ that are linear so that the trimming curves $\gamma\ell$ are necessarily straight lines;
  5. it uses only implicit representations $w_\ell$ of the form

$$w_\ell = \left(q_1 \cdots q_{\ell-1} q_{\ell+1} \cdots q_L\right)^r$$

so that the degree of the resulting surface is increasing with $L$ and the influence of the ribbon $\mathbf{r}_\ell$ extends to the whole surface.

One important aspect of the invention is a computer implemented method for running on a computer system for the purpose of geometric modeling, computer aided design, simulation, and visualization. It is allocating memory to store arrays of control points and knot vectors of the bivariate spline surfaces

$$\mathbf{b}, \mathbf{r}_1, \ldots, \mathbf{r}_L,$$

and the bivariate spline functions

$$w, w_1, \ldots, w_L, \gamma_1, \ldots, \gamma_L, \kappa_1, \ldots, \kappa_L,$$

and it is performing a computer calculation of a new spline surface $\mathbf{a}$ according to the formula

$$\mathbf{a} = \frac{w \cdot \mathbf{b} + \sum_{\ell=1}^{L} w_\ell \cdot \mathbf{r}_\ell \circ \kappa_\ell}{w + \sum_{\ell=1}^{L} w_\ell}$$

for further processing, exporting, displaying, or exchanging by the computer. The domain of this surface $\mathbf{a}$ is bounded by planar *trimming curves* $\gamma_1, \ldots, \gamma_L$, characterized by $w(\gamma\ell(u)) = 0$ and $\kappa\ell(\gamma\ell(u)) = (u, 0)$. Further, the scalar-valued splines $w_\ell$ are chosen such that $w_\ell$ vanishes at all trimming curves except for $\gamma\ell$. It is important to note that the trimming curves $\gamma\ell$ need not be computed explicitly. The *defining splines* $\kappa_\ell$ are used to reparametrize the ribbons $\mathbf{r}_\ell$ in order to correlate the parametrizations of the base $\mathbf{b}$ and the ribbons $\mathbf{r}_\ell$. The computation method for the surface a achieves a blend of the spline surface $\mathbf{b}$, called *base,* and the spline surfaces $\mathbf{r}_\ell$, called *ribbons,* such that the shape of $\mathbf{a}$ combines their features. In particular, when approaching the trimming curve $\gamma\ell$, all weights except for $w_\ell$ tend to zero so that the ribbon $\mathbf{r}_\ell$ becomes dominant and determines the shape of $\mathbf{a}$. Thus, the special construction faciliates an accurate boundary control of $\mathbf{a}$ at the trimming curves, what coins the name *ABC-surface* for $\mathbf{a}$.

In a preferred embodiment the defining spline $\kappa_\ell = [p_\ell \; q_\ell]$ is calculated such that the reparametrized ribbon $\mathbf{r}_\ell \circ \kappa_\ell$ approximates the base $\mathbf{b}$ in the vicinity of the trimming curve $\gamma_\ell$ by the following steps:

(a) setting knot vectors $S_\ell$, $T_\ell$ and coordinate degrees $n_\ell$, $m_\ell$ for the splines $p_\ell$, $q_\ell \in \mathbb{S}_0^1$;

(b) calculating lists of parameters $\sigma_\ell^k \in \mathbb{R}^2$ and $(u_\ell^k, v_\ell^k) \in \mathbb{R}^2$, $k \in K_\ell$, such that $\mathbf{b}(\sigma_\ell^k)$ is close to $\mathbf{r}_\ell(u_\ell^k, v_\ell^k)$, wherein preferably orthogonal projection is applied.

(c) setting subsets $K_\ell^1, K_\ell^2 \subset K_\ell$ of indices addressing interpolation points for $p_\ell$ and $q_\ell$ respectively;

(d) using an approximation technique, prefarably constrained least squares or smoothing spline, to calculate $p_\ell$ such that

$$p_\ell(\sigma_\ell^k) = u_\ell^k, \quad k \in K_\ell^1$$

$$p_\ell(\sigma_\ell^k) \approx u_\ell^k, \quad k \in K_\ell \setminus K_\ell^1;$$

(e) analogously, using an approximation technique to determine $q_\ell$ such that

$$q_\ell(\sigma_\ell^k) = v_\ell^k, \quad k \in K_\ell^2$$

$$q_\ell(\sigma_\ell^k) \approx v_\ell^k, \quad k \in K_\ell \setminus K_\ell^2.$$

The purpose of this method is to reconcile the otherwise incompatible parametrizations of **b** and $\mathbf{r}_\ell$. In Step (a), the basic properties of the splines $p_\ell$, $q_\ell$ are fixed. One possible choice is to use the same knots and coordinate degrees as given for the base **b**. In Step (b), pairs $\sigma_\ell^k, (u_\ell^k, v_\ell^k)$ of parameters are set for later use with approximation techniques. Closeness of $\mathbf{b}(\sigma_\ell^k)$ to $\mathbf{r}_\ell(u_\ell^k, v_\ell^k)$ can be achieved by requesting that the line that connects these two points is perpendicular to either **b** or $\mathbf{r}_\ell$. In Step (c), lists of indices corresponding to points that shall be interpolated are defined. Such points may be used to ensure that the defining splines $\kappa_\ell$ possess specific properties, like $\kappa_\ell(\gamma_\ell(1)) = \kappa_{\ell+1}(\gamma_{\ell+1}(0))$. In Steps (d) and (e), the scalar-valued splines $p_\ell$ and $q_\ell$ are determined such that the requested interpolation conditions are met and the deviation for the other points is small. For instance, the sum of squared deviations may be minimized. This yields a quadratic minimization problem with linear constraints, which can be solved efficiently. Equally, the fairness of the splines to be determined may be taken into account in the sense of familiar smoothing spline techniques.

According to another preferred embodiment, the method comprises the calculation of an implicit representation $w$ such that $w(\gamma_\ell(u)) = 0$ for all $\ell = 1, \ldots, L$ and $u \in [0, 1]$. The typical way to construct such a function $w$ is to mulitply factors, each of which is vanishing at one of the trimming curves $\gamma_\ell$ so that the product $w$ vanishes at all of them. In particular, one may use the components $q_\ell$ of the defining splines $\kappa_\ell = [p_\ell, q_\ell]$ or powers thereof as factors.

According to another preferred embodiment, the method comprises the calculation of an implicit representation $w_\ell$ such that $w_\ell(\gamma_\ell(u)) = 0$ for all $j = 1, \ldots, \ell - 1, \ell + 1, \ldots, L$ and $u \in [0,1]$. The typical way to construct such a function $w$ is to mulitply factors, each of which is vanishing at one of the trimming curves $\gamma_j$ except for $\gamma_\ell$ so that $w_\ell$ vanishes at all of them except for $\gamma_\ell$. In particular, one may use the components $q_j$ of the defining splines $\kappa_j = [p_j, q_j]$ or powers thereof as factors.

In another possible embodiment, the method for computing the implicit representations $w$ and $w_\ell$ is proceeding as follows:

(a) denoting by $\Sigma_\ell := \{\sigma \in \Gamma : q_\ell(\sigma) \le h_\ell\}$ the *boundary stripe* of $\gamma_\ell$ with width $h_\ell > 0$, set a value $h_\ell > 0$ such that only boundary stripes of neighboring curves intersect, and that this intersection consists of a single connected piece;

(b) deriving from $q_\ell$ a new spline $\bar{q}_\ell$ as follows: *(i)* classifying the indices in the B-spline representation $q_\ell = \sum_i q_\ell^i b_i$ according to

$$I_\ell := \{i : q_\ell(\sigma) = 0 \text{ for some } \sigma \in \operatorname{supp} b_i\}$$

$$J_\ell := \{i : q_\ell(\sigma) > h_\ell \text{ for some } \sigma \in \operatorname{supp} b_i\};$$

*(ii)* if the sets $I_\ell$ and $J_\ell$ are not disjoint, refine the B-spline representation of $q_\ell$ by knot insertion and repeat the first step: *(iii)* set

$$\bar{q}_\ell^i := \begin{cases} q_\ell^i & \text{if } i \in I_\ell \\ h_\ell & \text{if } i \in J_\ell, \end{cases}$$

where coefficients with indices neither in $I_\ell$ nor in $J_\ell$ are computed such that the resulting spline has reasonable shape, for instance by minimizing a standard fairness functional; *(iv)* calculate the spline $\bar{q}_\ell := \sum_i \bar{q}_\ell^i b_i$;

(c) using the desired multiplicity $r$, computing the implicit representation $w := (\bar{q}_1 \cdots \bar{q}_L)^r$ of the boundary curves $\gamma_1, \ldots, \gamma_L$ with plateau;

(d) computing the spline $q_\ell := \bar{q}_{\ell-1}\bar{q}_{\ell+1}$, thereby overwriting its former value, and apply to it the method described in Step (b), but now setting $\bar{q}_\ell^i := 0$ if $i \in J_\ell$;

(e) using the desired multiplicity $r$, computing the implicit representation $\omega_\ell := \bar{q}_\ell^r$ with zero plateau;

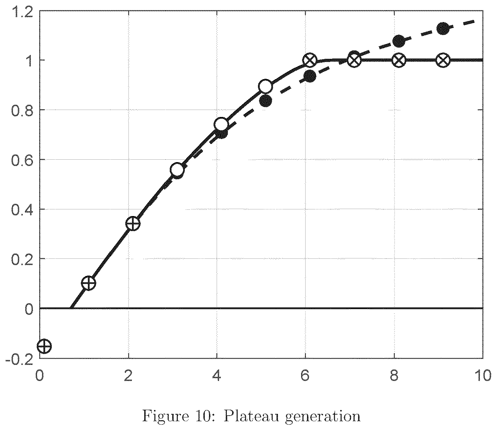

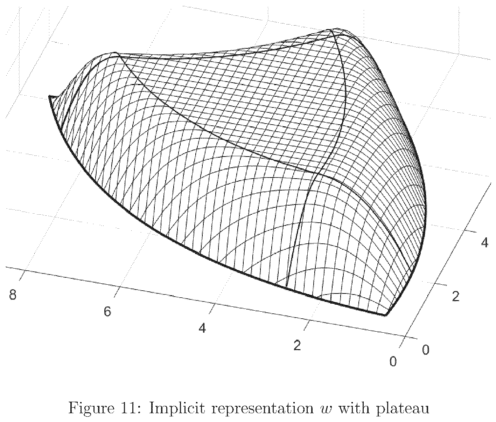

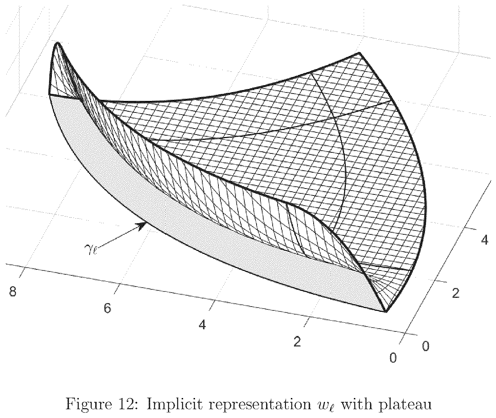

The purpose of this method is to limit the influence of the ribbon $\mathbf{r}_\ell$ to the vicinity of the trimming curve $\gamma_\ell$ and to keep the degree of the ABC-surface **a** low. In Step (a), the value of $h_\ell$ can be determined be starting from a relatively large value, and then shrinking it by a constant factor, say 1/2, until the desired property is achieved. That way, $h_\ell$ is small enough, but not much smaller than it needs to be. Note that excessively small widths of the boundary stripes may cause unwanted shape artifacts. Step (b) makes sure that B-splines $b_i$ affect the boundary if $i \in I_\ell$, and that they affect only the part beyond the boundary stripe if $i \in J_\ell$. By construction, $\bar{q}_\ell$ is an implicit representation of $\gamma_\ell$, but has a plateau with constant value $h_\ell$ beyond the boundary stripe $\Sigma_\ell$. Figure 10 illustrates the method. Step (c) multiplies powers of the previously defined functions to obtain an implicit representation $w$, see Figure 11. In Step (d), an implcit representation of the trimming curve $\gamma_\ell$ is constructed that vanishes beyond the boundary stripe, and eventually, in Step (e), this function is raised to the desired power $r$, see Figure 12.

Another embodiment comprises a computer configured for geometric modeling, computer aided design, simulation, and visualization having a storage device storing a surface representation according to the method steps. The computer can be a CAD/CAM Workstation displaying the representation of the information on a display in a 2D or 3D model or exporting the information as a 2D or 3D representation. Based on the information, G-Code or STL (Standard Triangulation/Tesselation Language) data can be generated for processing the information in 3D-Printers or CNC-machines. Other representations are possible.

## 4 Brief description of figures

In the following the figures of possible embodiments will be shortly introduced.

Figure 1 shows a parametrizing spline. The spline $p$ parametrizes the curve $\gamma$ according to $p(\gamma(u)) = u$ for $0 \leq u \leq 1$. The figure shows the spline $p$ together with a few level sets and also the curves $\gamma(u)$ and $p(\gamma(u))$.

Figure 2 shows an implicit representation $q$ of the curve $\gamma$, characterized by $q(\gamma(u)) = 0$ for $0 \leq u \leq 1$.

Figure 3 shows a base **b** and three ribbons $\mathbf{r}_\ell$ together with the trimming curves $\mathbf{r}_\ell(\cdot, 0)$.

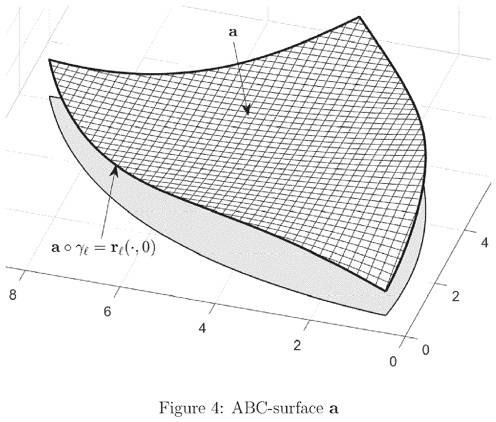

Figure 4 shows an ABC-surface **a.** Blending base and ribbons yields the ABC-surface **a** with boundary curves determined by the ribbons.

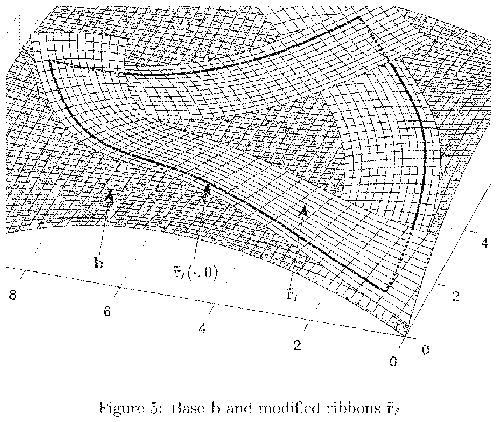

Figure 5 shows a base **b** and modified ribbons $\tilde{\mathbf{r}}_\ell$. Here, one ribbon is modifed to illustrate the shape properties of the method.

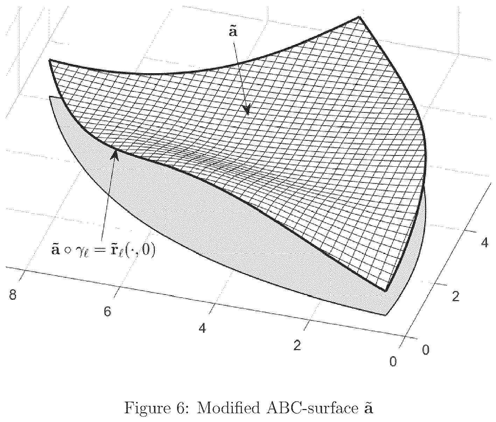

Figure 6 shows a modified ABC-surface **ã**. The resulting ABC-surface **ã** follows the modified shape of the boundary curve. Further, also boundary normals and curvature tensors are inherited from the ribbons since all implicit representations have multiplicity $r = 3$ so that **ã** has contact order $k = 2$.

Figure 7 shows an implicit representation $w$. The product $w := q_1 \cdots q_L$ yields a representation for the trimming curves $\gamma_1, \ldots, \gamma_L$ with multiplicity $r = 1$.

Figure 8 shows an implicit representation $w_\ell$. The product

$$w_\ell := q_1 \cdots q_{\ell-1} q_{\ell+1} \cdots q_L$$

yields a representation for all trimming curves but $\gamma_\ell$ with multiplicity $r = 1$.

Figure 9 shows boundary stripes $\Sigma_\ell$ corresponding to the boundary curves $\gamma_\ell$. The stripes must be narrow enough to ensure that the intersection $\Sigma_{\ell-1} \cap \Sigma_\ell$ of neighboring stripes consists of a single connected piece.

Figure 10 shows a one-dimensional analogue of generating a plateau for implicit representations. The dashed line is the original spline of degree 2 and the bullets (•) indicate its B-spline coefficients. The first three coefficients (⊕) with indices in 7 influencing the boundary are fixed. Chosing the value $\delta_\ell = 1$, the coefficients (⊕) with indices in $J$ are set to 1. The intermediate three coefficients (o), which are not restricted, are modified slightly to moderate the transition.

Figure 11 shows an implicit representation $w$ with plateau. Modifying the splines $q_\ell$ such that they are constant beyond the corresponding boundary stripes yields an implicit representation $w := (\bar{q}_1 \cdots \bar{q}_L)^r$ with plateau, shown here for multiplicity $r = 1$.

Figure 12 shows an implicit representation $w_\ell$ with plateau. Modifying the splines $q_\ell$ again such that they vanish beyond the corresponding boundary stripes yields an implicit representation $w_\ell := \bar{q}_\ell^r$ with zero plateau, shown here for multiplicity $r = 1$.

Figure 13 shows general level sets $\mu_\ell^i$. In general, the level sets $\mu_\ell^i$ of the spline $p_\ell$ with values equal to the knots $u_\ell^i$ are bended and cannot be represented by a spline curve. Parts of the level sets in regions where $w_\ell$ vanishes, here indicated by dotted lines, can be ignored.

Figure 14 shows straight level sets $\mu_\ell^i$. Using the special construction of defining splines according to Section 5.6 yields straight level sets $\mu_\ell^i$.

Figure 15 shows a partition of the domain $\Gamma$. The domain $\Gamma$ is subdivided into an interior part $\Gamma_0$ and boundary parts $\Gamma_\ell^i$ by means of boundary curve segments $\gamma_\ell^i$, level sets $\mu_\ell^i$, and auxiliary splines $\alpha_\ell^i$ to facilitate data export.

## 5 Detailed description

### 5.1 Definitions

Throughout, boldface letters denote points and functions with values in $\mathbb{R}^3$, while greek letters denote points and functions with values in $\mathbb{R}^2$. The following definitions are crucial for the construction of ABC-surfaces:

1. It is denoted by $\mathbb{S}^d$ the space of all $\mathbb{R}^d$-valued bivariate rational tensor product splines of arbitrary degree with finite, but otherwise arbitrary knot vectors. The subspace of purely polynomial splines (i.e., rational splines with constant denominator) is denoted by $\mathbb{S}_0^d$. Given a spline $f \in f \in \mathbb{S}^d$, it is denoted by deg $f$ its coordinate degree, and by knot$_1$ $f$ and knot$_2$ $f$ its two knot vectors. A *grid cell* is a rectangle bounded by neighboring knot lines.

2. A *semi-Bézier spline surface* $\mathbf{r} \in \mathbb{S}^3$ is characterized by the fact that, for fixed $u$, the function $\mathbf{r}(u, \cdot)$ is a Bézier curve. This means that knot$_2$ $\mathbf{r} = [a, \ldots, a, b, \ldots, b]$ consists of the two $(m+1)$-fold knots $a$ and $b$, where deg $\mathbf{r} = [n, m]$.

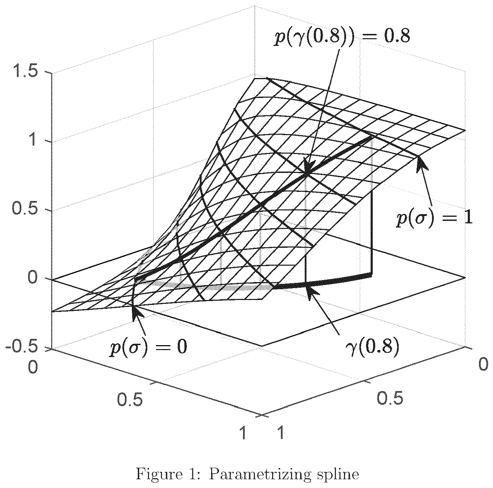

3. A spline $p \in \mathbb{S}^1$ *parametrizes* the planar curve $\gamma : [0, 1] \to \mathbb{R}^2$ if $p(\gamma(u)) = u$ for all $u \in [0, 1]$, see Figure 1.

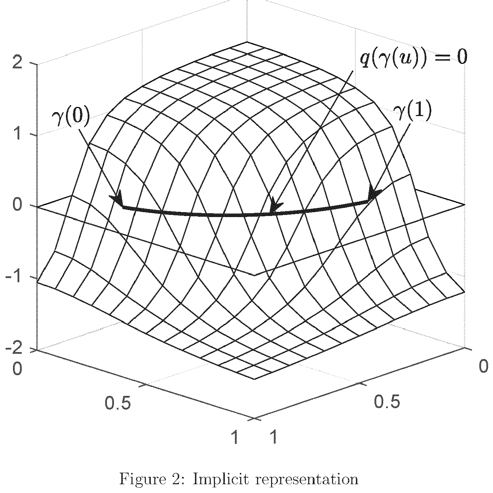

4. A spline $q \in \mathbb{S}^1$ is an *implicit representation* of the planar curve $\gamma$ if $q(\gamma(u)) = 0$ for all $u \in [0,1]$, see Figure 2. It has *multiplicity* $r$ if all partial derivatives or order less than $r$ vanish at $\gamma$. In particular, for $r = 2$, the gradient vanishes, and for $r = 3$, also the Hessian vanishes there.

5. $\kappa := [p, q] \in \mathbb{S}^2$ is called a *defining spline for* $\gamma$ if there exists a unique curve $\gamma : [0, 1] \to \mathbb{R}^2$ with implicit representation $q$ that is parametrized by $p$.

It is remarked that the notions *curve* and *surface* are used with a double meaning: In actual fact, a curve is a continuous mapping from an interval of the real axis to $\mathbb{R}^d$, and a surface is a continuous mapping from a subset of $\mathbb{R}^2$ to $\mathbb{R}^3$. However, following widespread practice, the same words are used when, strictly speaking, the image of these functions is meant.

### 5.2 Construction principle

The construction of a surface a is described, whose domain $\Gamma \subset \mathbb{R}^2$ of definition is bounded by a sequence $\gamma_1, \ldots, \gamma_L$ of planar trimming curves $\gamma_\ell : [0, 1] \to \mathbb{R}^2$, forming a closed loop. Throughout, the index $\ell$ runs from 1 through $L$ and is understood modulo $L$. The building blocks for our construction are the following:

1. Let $\kappa_\ell := [p_\ell, q_\ell] \in \mathbb{S}^2$ be defining splines for the trimming curves $\gamma_\ell$, forming a closed loop according to

$$\gamma_\ell(1) = \gamma_{\ell+1}(0), \quad \ell = 1, \ldots, .$$

The domain $\Gamma$ is the subset of $\mathbb{R}^2$ that is bounded by the trimming curves, and their common endpoints are the *corners* of $\Gamma$.

2. Let $w \in \mathbb{S}^1 \in$ be an implicit representation of all trimming curves. That is,

$$w(\gamma_j(u)) = 0, \quad j = 1, \ldots, L, \ u \in [0,1].$$

Further, it is assumed that $w$ is positive on the interior of $\Gamma$.

3. For each $\ell$, let $w_\ell \in \mathbb{S}^1$ be an implicit representation of all trimming curves but $\gamma_\ell$. That is,

$$w_\ell(\gamma_j(u)) = 0, \quad j = 1, \ldots, \ell-1, \ell+1, \ldots, L, \ u \in [0,1].$$

Further, it is assumed that $w_\ell$ is non-negative on $\Gamma$, and that the only zeros of the sum $\Sigma_\ell\, w_\ell$ in $\Gamma$ are the corners.

4. Let $\mathbf{b} \in \mathbb{S}^3$ be a spline surface, called the *base.*

5. For each $\ell$, let $\mathbf{r}_\ell \in \mathbb{S}^3$ be a spline surface, called *ribbon.*

With these ingredients, a new surface **a** is constructed by means of the formula

$$\mathbf{a} := \frac{w \cdot \mathbf{b} + \sum_{\ell=1}^{L} w_\ell \cdot \mathbf{r}_\ell \circ \kappa_\ell}{w + \sum_{\ell=1}^{L} w_\ell}.$$

Since the right hand side is not yet well defined at corners, it is further stipulated

$$\mathbf{a}(\gamma_\ell(0)) := \mathbf{r}_\ell(0,0), \quad \ell = 1, \ldots, L.$$

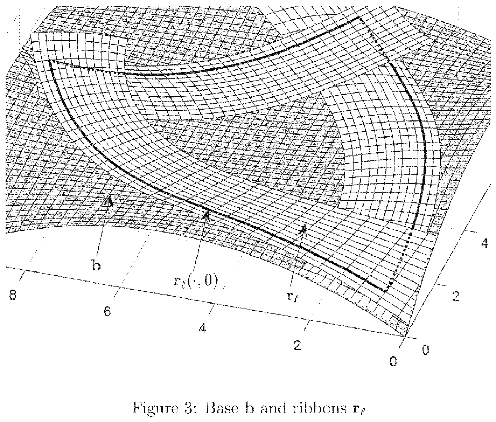

If all implicit representations $w$ and $w_\ell$ appearing above have multiplicity $r$, then it is assumed that **a** has *contact order* $k := r - 1$. The domain of **a** is the set $\Gamma$, whose boundary is formed by the curves $\gamma_1, \ldots, \gamma_L$. As will be made precise below, the ribbons $\mathbf{r}_\ell$, provide accurate boundary control for **a,** giving rise to the acronym *ABC-surface.* Figures 3, $\ldots$, 6 illustrate the setting.

### 5.3 Basic properties

ABC-surfaces have the following properties:

1. The function **a** is piecewise rational. To bound the degree of its pieces, it is assumed, for simplicity, that all splines appearing in its definition are polynomial. The first summand in the numerator has degree at most $d_1 := \deg w + \deg \mathbf{b}$. Denoting the total degree of $\mathbf{r}_\ell$ by $|\deg r_\ell|$, the second summand has coordinate degree at most

$$d_2 := \max_\ell \big\{ \deg w_\ell + |\deg \mathbf{r}_\ell| \deg \kappa_\ell \big\}.$$

Since the degree of the denominator does not exceed $d_1$ and $d_2$, it holds $\deg \mathbf{a} \le \max\{d_1, d_2\}$.

2. When evaluating **a** at the trimming curve $\gamma_\ell$, only a single summand does not vanish, and it is obtained

$$\mathbf{a}(\gamma_\ell(u)) = \mathbf{r}_\ell(u,0), \quad 0 < u < 1.$$

That is, the boundary curves of **a** are determined by the ribbons.

3. Denote the normalized normal vector of $\mathbf{r}_\ell$ by $\mathbf{n}_\ell$, and the normalized normal vector of **a** by **n**. If the surface **a** has contact order 1, then it has the boundary normals

$$\mathbf{n}(\gamma_\ell(u)) = \mathbf{n}_\ell(u,0), \quad 0 < u < 1.$$

That is, the boundary normals of **a** are determined by normals of the ribbons.

4. Denote the curvature tensor of $\mathbf{r}_\ell$ by $E_\ell$, and the curvature tensor of **a** by $E$. If the surface **a** has contact order 2, then it has the boundary curvature tensors

$$E(\gamma_\ell(u)) = E_\ell(u, 0), \quad 0 < u < 1.$$

That is, the boundary curvature tensors of **a** are determined by curvature tensors of thw ribbons.

Properties 2, 3, 4 remain valid even at the endpoints $u \in \{0,1\}$ if, respectively, values, normals, and curvature tensors of neighboring ribbons coincide at the corners.

### 5.4 Construction of defining splines

In this section, it is described how to construct defining splines $\kappa_\ell$ from given ribbons $\mathbf{r}_\ell$ and base **b**.

In principle, the defining splines $\kappa_\ell$ can be chosen independently of the other data. For instance, the curves $\gamma_\ell$ could be made straight lines forming a regular $L$-gon. However, in many cases, it is advantageous to modify the parametrization of the base **b** not more than necessary to blend it into the ribbons $\mathbf{r}_\ell$ when approaching the trimming curves. To achieve this, one determines defining splines $\kappa_\ell$ for given **b**, $\mathbf{r}_\ell$ such that $\mathbf{b} \approx \mathbf{r}_\ell \circ \kappa_\ell$. It is now a prototype method described to achieve this. For all $\ell$, do:

1. Choose knot vectors $S_\ell$, $T_\ell$ and coordinate degrees $[n_\ell, m_\ell]$ for the splines $p_\ell, q_\ell \in \mathbb{S}_0^1$.

2. Choose sufficiently many parameters $\sigma_\ell^k \in \mathbb{R}^2$ and $(u_\ell^k, v_\ell^k) \in \mathbb{R}^2$, $k \in K_\ell$ such that $\mathbf{b}(\sigma_\ell^k) \approx \mathbf{r}_\ell(u_\ell^k, v_\ell^k)$. To this end, standard methods like orthogonal projection can be applied.

3. Select subsets $K_\ell^1, K_\ell^2 \subset K_\ell$ of indices addressing interpolation points for $p_\ell$ and $q_\ell$, respectively.

4. Use a standard approximation technique (e.g., constrained least squares or smoothing spline) to determine $p_\ell$ such that

$$p_\ell(\sigma_\ell^k) = u_\ell^k, \quad k \in K_\ell^1$$

$$p_\ell(\sigma_\ell^k) \approx u_\ell^k, \quad k \in K_\ell \setminus K_\ell^1.$$

5. Analogously, use a standard approximation technique to determine $q_\ell$ such that

$$q_\ell(\sigma_\ell^k) = v_\ell^k, \quad k \in K_\ell^2$$

$$q_\ell(\sigma_\ell^k) \approx v_\ell^k, \quad k \in K_\ell \setminus K_\ell^2.$$

In steps 4 and 5, interpolation conditions can be used in particular to assure that neighboring trimming curves join according to $\gamma_\ell(1) = \gamma_{\ell+1}(0)$, as requested. If one of the problems is overconstrained by interpolation conditions and hence unsolvable, one may either relax the conditions or enlarge the underlying spline space by refining the knot vectors $S_\ell$, $T_\ell$ If, conversely, one of the problems is underconstrained and hence possesses multiple solutions, one may either add more points or regularize the problem by employing a standard fairness functional.

### 5.5 Construction of implicit representations

The functions $q_\ell$ constructed for the defining splines can be reused to determine implicit representations $w$ and $w_\ell$. The obvious choices

$$w := (q_1 \cdots q_L)^r$$

$$w_\ell := (q_1 \cdots q_{\ell-1} q_{\ell+1} \cdots q_L)^r,$$

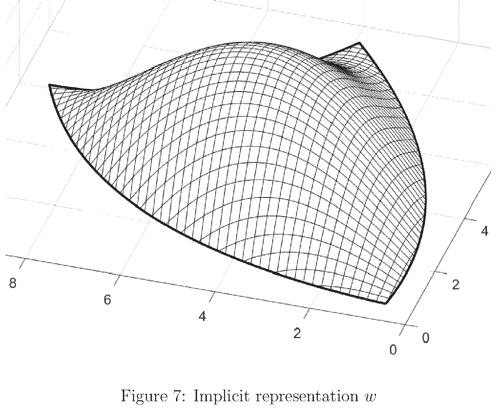

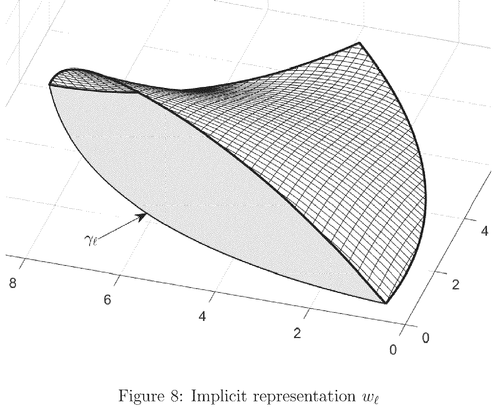

as shown in figures 7 and 8 for multiplicity $r = 1$, are valid, but their degree, growing linearly with $L$, is unnecessarily high. Further, with these settings, the influence of the ribbon $\mathbf{r}_\ell$ extends to the whole domain, what might be undesired. It is now described a prototype method to achieve modest degrees, and to limit the influence of ribbons to a neighborhood of the corresponding trimming curve. For all $\ell$, do:

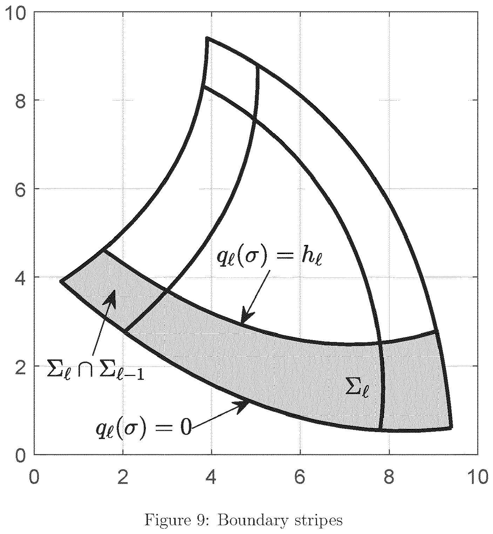

1. Denote by $\Sigma_\ell := \{\sigma \in \Gamma : q_\ell(\sigma) \leq h_\ell\}$ the *boundary stripe* of $\gamma_\ell$ with width $h_\ell > 0$. Choose $h_\ell > 0$ small enough to make sure that only boundary stripes of neighboring curves intersect, and that this intersection consists of a single connected piece, see Figure 9.

2. Derive from $q_\ell$ a new spline $\overline{q}_\ell$ as follows: First, classify the indices in the B-spline representation $q_\ell = \sum_i q_\ell^i b_i$ according to

$$I_\ell := \left\{i : q_\ell(\sigma) = 0 \text{ for some } \sigma \in \operatorname{supp} b_i\right\}$$

$$J_\ell := \left\{i : q_\ell(\sigma) > h_\ell \text{ for some } \sigma \in \operatorname{supp} b_i\right\}.$$

That is, B-splines $b_i$ affect the boundary if $i \in I_\ell$, and they affect the part beyond the boundary stripe if $i \in J_\ell$. Second, if the sets $I_\ell$ and $J_\ell$ are not disjoint, refine the B-spline representation of $q_\ell$ by knot insertion and repeat the first step. Third, set

$$\overline{q}_\ell^i := \begin{cases} q_\ell^i & \text{if } i \in I_\ell \\ h_\ell & \text{if } i \in J_\ell. \end{cases}$$

Coefficients with indices neither in $I_\ell$ nor in $J_\ell$ are determined such that the resulting spline has reasonable shape, for instance by minimizing a standard fairness functional. Fourth, define the spline $\overline{q}_\ell := \sum_i \overline{q}_\ell^i b_i$. By construction, $\overline{q}_\ell$ is an implicit representation of $\gamma_\ell$, but has a plateau with constant value $h_\ell$ beyond the boundary stripe $\Sigma_\ell$. Figure 10 illustrates the method.

3. Given the desired multiplicity $r$, define the implicit representation $w := (\overline{q}_1 \cdots \overline{q}_L)^r$ of the boundary curves $\gamma_1, \ldots, \gamma_L$ with plateau, see Figure 11. By construction, the coordinate degree of $w$ is bounded by

$$\deg w \leq 2r \left[\max_\ell n_\ell, \max_\ell m_\ell\right]$$

since at any given point $\sigma \in \Gamma$ at most two factors are non-constant.

4. Redefine the spline $q_\ell := \overline{q}_{\ell-1}\overline{q}_{\ell+1}$. Apply to it the method described in Step 2, but now setting $\overline{q}_\ell^i := 0$ if $i \in J_\ell$.

5. Given the desired multiplicity $r$, define the implicit representation $\omega_\ell := \overline{q}_\ell^r$ with zero plateau, see Figure 12. It vanishes at all trimming curves but $\gamma_\ell$ and also beyond the boundary stripe $\Sigma_\ell$. This implies that the influence of the ribbon $\mathbf{r}_\ell$ is limitted to a neigborhood of the corresponding segment of the boundary. The degree of $\omega_\ell$ is bounded by

$$\deg w_\ell \leq r \left[\max\{n_{\ell-1}, n_{\ell+1}\}, \max\{m_{\ell-1}, m_{\ell+1}\}\right].$$

## 5.6 Special construction of defining splines

The surface a is piecewise polynomial, but in general not ready for direct export to standard file formats, like IGES or STEP. The problem is that the knots $u_\ell^i \in \operatorname{knot}_1 \mathbf{r}_\ell$ of the ribbons $\mathbf{r}_\ell$ reemerge in a along the level sets

$$\mu_\ell^i := \left\{\sigma \in \Gamma : p_\ell(\sigma) = u_\ell^i \text{ and } w_\ell(\sigma) > 0\right\},$$

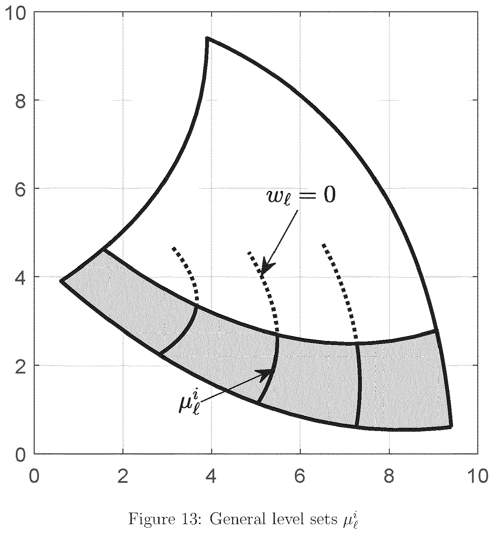

causing certain higher order derivatives of a to be discontinuous there. Further, neither $\mu_\ell^i$ nor its image $\mathbf{r}_\ell\!\left(\mu_\ell^i\right)$ is, in general, a spline curve, see Figure 13. To solve this problem, it is assumed that the ribbons $\mathbf{r}_\ell$ are semi-Bézier spline surfaces. Then, Step 5 in the construction of defining splines is replaced by the following method to force the curves $\mu_\ell^i$ to be straight lines:

5.1. For each knot $u_\ell^i \in \mathrm{knot}_1\, \mathbf{r}_\ell$ choose a direction $\delta_\ell^i \in \mathbb{R}^2$ such that

$$\mathbf{r}_\ell(u_\ell^i, t) \approx \mathbf{b}\big(\gamma_\ell(u_\ell^i) + t\delta_\ell^i\big)$$

for arguments $\gamma_\ell(u_\ell^i) + t\delta_\ell^i$ within the boundary stripe $\Sigma_\ell$. Denoting by $Db^+ := (Db^T Db)^{-1} Db^T$ the pseudo-inverse of the Jacobian Db, one may set in particular

$$\delta_\ell^i := D\mathbf{b}^+(\gamma_\ell(u_\ell^i)) \cdot \partial_2 \mathbf{r}_\ell(u_\ell^i, 0).$$

5.2. Define the line segment

$$\mu_\ell^i := \big\{\gamma_\ell^i + t\delta_\ell^i : t \in \mathbb{R}\big\} \cap \Sigma_\ell$$

with direction $\delta_\ell^i$ within the boundary stripe $\Sigma_\ell$.

5.3. Choose a finite subset $\Sigma_\ell^i = \{\tilde{\sigma}_\ell^k : k \in \tilde{K}_\ell^i\} \subset \mu_\ell^i$ of the line segment such that for each grid cell $\Delta$ that intersects $\mu_\ell^i$, there exist at least $m_\ell + 1$ pairwise different points in $\Sigma_\ell^i \cap \Delta$, where $[n_\ell, m_\ell] = \deg \mathbf{r}_\ell$.

5.4. Determine $p_\ell$ such that

$$p_\ell(\sigma_\ell^k) = u_\ell^k, \quad k \in K_\ell^1$$

$$p_\ell(\sigma_\ell^k) \approx u_\ell^k, \quad k \in K_\ell \setminus K_\ell^1$$

$$p_\ell(\tilde{\sigma}_\ell^k) = u_\ell^i, \quad k \in \tilde{K}_\ell^i.$$

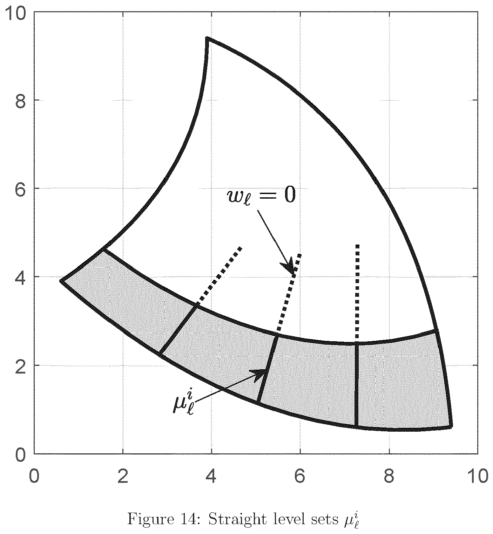

Figure 14 illustrates the result.

**5.7 Data export**

To exchange data between CAD/CAM systems, the ABC-surface **a,** or at least a sufficiently accurate approximation thereof, must be filed in a standard format, like IGES or STEP. The following methods are suggested:

1. Appoximate **a** by some spline surface $\tilde{\mathbf{a}} \in \mathbb{S}^3$ with given knots and coordinate degree using a standard technique, like least squares. By refining the knot sequences, any given approximation tolerance can be met. The advantage of this method is that the degree of the output **ã** can be chosen independently of the degree of the components of a, which might be quite high. Further, **ã** can be stored as a single trimmed NURBS object. On the other hand, the exact boundary fit is typically lost.

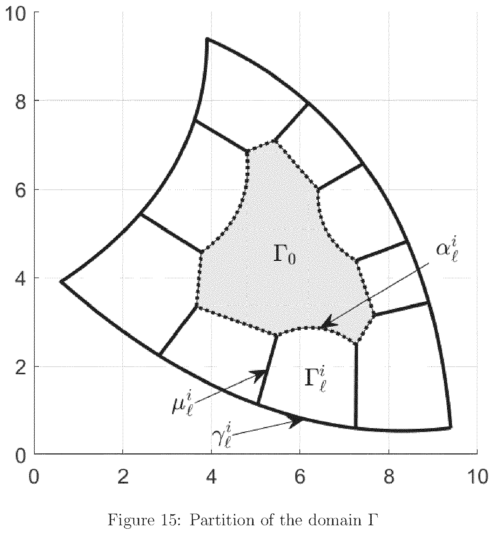

2. This method assumes that the ribbons $\mathbf{r}_\ell$ are of semi-Bézier type and that the level sets $\mu_\ell^i$ are straight, as described in Section 5.6. Partition the domain $\Gamma$ into an interior part $\Gamma_0$ and boundary parts $\Gamma_\ell^i$ by a network of curves, consisting of three different types: First, there are the segments $\gamma_\ell^i$ of the trimming curves $\gamma_\ell$ corresponding to intervals between consecutive knots in knot$_1$ $\mathbf{r}\ell$. Second, there are the level sets $\mu_\ell^i$, and third, there are auxiliary spline curves $\alpha_\ell^i$, to be chosen at will, connecting the endpoints of the level sets. Figure 15 illustrates the setting. Restricting the ABC-surface $\mathbf{a}$ to the subdomains $\Gamma_0$, $\Gamma_\ell^i$ yields pieces $\mathbf{a}_0$, $\mathbf{a}_\ell^i$, respectively, which are trimmed NURBS surfaces ready for filing with standard data formats. They do not have interior breaks aside from a regular knot grid, and their boundaries are formed by spatial spline curves $\mathbf{a} \circ \gamma_\ell^i$ and planar spline curves $\mu_\ell^i, \alpha_\ell^i$.

**6 References**

[1] B. Marussig and T.J.R. Hughes, A Review of Trimming in Isogeometric Analysis: Challenges, Data Exchange and Simulation Aspects, Archives of Computational Methods in Engineering 25(4), 1059-1127 (2018).

[2] J. Peters and U. Reif Subdivision surfaces, Series Geometry and Computing, Vol. 3, Springer (2008).

[3] Th.W. Sederberg, System and method for defining T-spline and T-NURCC surfaces using local refinements, US patent US7274364B2 (2007).

[4] T. Várady, P. Salvi, and G. Kariká, Enhancement of a multi-sided Bézier surface representation, Computer Aided Geometric Design 55(69), 69-83 (2017).

[5] N. Pla-Garcia, M. Vigo-Anglada, and J. Cotrina-Navau, N-sided patches with B-spline boundaries, Computers and Graphics 30(6), 959-970 (2006).

[6] J. Peters, Geometric continuity, in Handbook of Computer Aided Geometric Design, G. Farin, J. Hoschek, M.S. Kim (eds.), ISBN 9780444511041, 193-227 (2002).

**Claims**

1. A computer implemented method for generating a surface representation for processing in 3D-printers or CNC machines, which is allocating memory to store arrays of control points and knot vectors of the bivariate spline surfaces

$$\mathbf{b}, \mathbf{r}_1, \ldots, \mathbf{r}_L,$$

of the bivariate spline functions

$$\kappa_1 = [p_1, q_1], \ldots, \kappa_L = [p_L, q_L],$$

which define trimming curves $\gamma_\ell$ with implicit representation qe and parametrized by $p_\ell$, $\ell = 1, \ldots, L$, of a bivariate spline function $w$ being an implicit representation of all trimming curves, and of bivariate spline functions

$$w_1, \ldots, w_L,$$

where $w_\ell$ is an implicit representation of all trimming curves but $\gamma_\ell$, $\ell = 1, \ldots, L$, and which is performing a computer calculation of a new spline surface a, bounded by the sequence of trimming curves $\gamma_\ell$ forming a closed loop, according to the formula

$$\mathbf{a} = \frac{w \cdot \mathbf{b} + \sum_{\ell=1}^{L} w_{\ell} \cdot \mathbf{r}_{\ell} \circ \kappa_{\ell}}{w + \sum_{\ell=1}^{L} w_{\ell}}$$

for further processing, exporting, displaying, or exchanging by the computer, and which is generating data from the new spline surface **a** for processing in 3D-printers or CNC machines.

2. The computer implemented method according to Claim 1 wherein the defining spline $\kappa_{\ell} = [p_{\ell}, q_{\ell}]$ is calculated such that the reparametrized ribbon $\mathbf{r}_{\ell} \circ \kappa_{\ell}$ approximates the base **b** in the vicinity of the trimming curve $\gamma_{\ell}$ by the following steps:

(a) setting knot vectors $S_{\ell}$, $T_{\ell}$ and coordinate degrees $n_{\ell}$, $m_{\ell}$ for the splines $p_{\ell}, q_{\ell} \in \mathbb{S}_0^1$ ;

(b) calculating lists of parameters $\sigma_{\ell}^k \in \mathbb{R}^2$ and $(u_{\ell}^k, v_{\ell}^k) \in \mathbb{R}^2$ , $k \in K_{\ell}$, such that $\mathbf{b}(\sigma_{\ell}^k)$ is close to $\mathbf{r}_{\ell}(u_{\ell}^k, v_{\ell}^k)$ , wherein preferably orthogonal projection is applied.

(c) setting subsets $K_{\ell}^1, K_{\ell}^2 \subset K_{\ell}$ of indices addressing interpolation points for $p_{\ell}$ and $q_{\ell}$, respectively;

(d) using an approximation technique, prefarably constrained least squares or smoothing spline, to calculate $p_{\ell}$ such that

$$p_{\ell}(\sigma_{\ell}^k) = u_{\ell}^k, \quad k \in K_{\ell}^1$$

$$p_{\ell}(\sigma_{\ell}^k) \approx u_{\ell}^k, \quad k \in K_{\ell} \setminus K_{\ell}^1;$$

(e) analogously, using an approximation technique to determine $q_{\ell}$ such that

$$q_{\ell}(\sigma_{\ell}^k) = v_{\ell}^k, \quad k \in K_{\ell}^2$$

$$q_{\ell}(\sigma_{\ell}^k) \approx v_{\ell}^k, \quad k \in K_{\ell} \setminus K_{\ell}^2.$$

3. The computer implemented method according to Claim 1 or Claim 2, calculating the implicit representation $w$ such that $w(\gamma_j(u)) = 0$ for $j = 1, \ldots, L$ and $u \in [0, 1]$.

4. The computer implemented method according to Claim 1 or Claim 2, calculating the implicit representation $w_{\ell}$ such that $w_{\ell}(\gamma_j)) = 0$ for $j = 1, \ldots \ell - 1, \ell + 1, \ldots, L$ and $u \in [0, 1]$.

5. The computer implemented method according to any of the claims 1 to 4, wherein the calculation of implicit representations $w$ and $w_{\ell}$ is proceeding as follows:

(a) denoting by $\Sigma_{\ell} := \{\sigma \in \Gamma : q_{\ell}(\sigma) \leq h_{\ell}\}$ the *boundary stripe* of $\gamma_{\ell}$ with width $h_{\ell} > 0$, set a value $h_{\ell} > 0$ such that only boundary stripes of neighboring curves intersect, and that this intersection consists of a single connected piece;

(b) deriving from $\bar{q}_{\ell}$ a new spline $\bar{q}_{\ell}$ as follows: *(i)* classifying the indices in the B-spline representation $q_{\ell} = \sum_i q_{\ell}^i b_i$ according to

$$I_{\ell} := \{i : q_{\ell}(\sigma) = 0 \text{ for some } \sigma \in \operatorname{supp} b_i\}$$

$$J_{\ell} := \{i : q_{\ell}(\sigma) > h_{\ell} \text{ for some } \sigma \in \operatorname{supp} b_i\};$$

*(ii) if the sets $I_\ell$ and $J_\ell$ are not disjoint, refine the B-spline representation of $q_\ell$ by knot insertion and repeat the first step; (iii) set*

$$\bar{q}_\ell^i := \begin{cases} q_\ell^i & \text{if } i \in I_\ell \\ h_\ell & \text{if } i \in J_\ell, \end{cases}$$

where coefficients with indices neither in $I_\ell$ nor in $J_\ell$ are computed such that the resulting spline has reasonable shape, for instance by minimizing a standard fairness functional; *(iv)* calculate the spline $\bar{q}_\ell := \sum_i \bar{q}_\ell^i b_i$ ;

(c) using the desired multiplicity *r*, computing the implicit representation $w := (\bar{q}_1 \cdots \bar{q}_L)^r$ of the boundary curves $\gamma_1, \ldots, \gamma_L$ with plateau;

(d) computing the spline $q_\ell := \bar{q}_{\ell-1} \bar{q}_{\ell+1}$, thereby overwriting its former value, and apply to it the method described in Step (b), but now setting $\bar{q}_\ell^i := 0$ if $i \in J_\ell$;

(e) using the desired multiplicity *r*, computing the implicit representation $\omega_\ell := \bar{q}_\ell^r$ with zero plateau;

**6.** A computer configured for geometric modeling, computer aided design, simulation, and visualization having means to generate a surface representation according to one or more of the preceding method claims.

## Patentansprüche

**1.** Computerimplementiertes Verfahren zur Erzeugung einer Oberflächendarstellung zur Verarbeitung in 3D-Druckern oder CNC-Maschinen, das Speicher zum Speichern von Arrays von Kontrollpunkten und Knotenvektoren der bivariaten Spline-Oberflächen zuweist

$$\mathbf{b}, \mathbf{r}_1, \ldots, \mathbf{r}_L,$$

der bivariaten Spline-Funktionen

$$\kappa_1 = [p_1, q_1], \ldots, \kappa_L = [p_L, q_L],$$

die Trimmkurven $\gamma_\ell$ mit impliziter Darstellung $q_l$ definieren und parametrisiert durch $p_\ell$ $\ell = 1, \ldots, L$, einer bivariaten Spline-Funktion *w*, die eine implizite Darstellung aller Trimmkurven ist, und eines bivariaten Splines Funktionen

$$w_1, \ldots, w_L,$$

wobei $w_\ell$ eine implizite Darstellung aller Trimmkurven ist, aber $\gamma_\ell$ $\ell = 1, \ldots, L$, und der eine Computerberechnung eines neuen Spline-Fläche **a,** begrenzt durch die Folge von Trimmkurven $\gamma_\ell$, die eine geschlossene Schleife bilden, nach der Formel

$$\mathbf{a} = \frac{w \cdot \mathbf{b} + \sum_{\ell=1}^L w_\ell \cdot \mathbf{r}_\ell \circ \kappa_\ell}{w + \sum_{\ell=1}^L w_\ell}$$

für die Weiterverarbeitung, den Export, die Anzeige oder den Austausch durch den Computer, der aus der neuen Splinefläche **a** Daten für die Verarbeitung in 3D-Druckern oder CNC-Maschinen erzeugt.

**2.** Computerimplementiertes Verfahren nach Anspruch 1, bei dem der definierende Spline $\kappa_\ell = [p_\ell, q_\ell]$ so berechnet wird, dass das reparametrisierte Band $r_\ell \circ \kappa_\ell$ die Basis **b** in der Nähe der Trimmkurve $\gamma_\ell$ durch die folgenden Schritte approximiert:

a) Setzen von Knotenvektoren $S_\ell$, $T_\ell$ und Koordinatengraden $n_\ell$, $m_\ell$, für die Splines $p_\ell, q_\ell \in \mathbb{S}_0^1$;

b) die Berechnung von Listen der Parameter $\sigma_\ell^k \in \mathbb{R}^2$ and $(u_\ell^k, v_\ell^k) \in \mathbb{R}^2$, $k \in K_\ell$ so dass $\mathbf{b}(\sigma_\ell^k)$ in der Nähe von $\mathbf{r}_\ell(u_\ell^k, v_\ell^k)$ liegt wobei vorzugsweise orthogonale Projektion angewendet wird.

c) Festlegung von Teilmengen $K_\ell^1, K_\ell^2 \subset K_\ell$ von Indizes für die Interpolation Punkte für $p_\ell$ bzw. $q_\ell$;

d) mit Hilfe eines Näherungsverfahrens, vorzugsweise der eingeschränkten kleinsten Quadrate oder der Glättungsspline, $p_\ell$ so zu berechnen, dass

$$p_\ell(\sigma_\ell^k) = u_\ell^k, \quad k \in K_\ell^1$$

$$p_\ell(\sigma_\ell^k) \approx u_\ell^k, \quad k \in K_\ell \setminus K_\ell^1;$$

e) Analog dazu kann man mit Hilfe eines Näherungsverfahrens $q_\ell$ derart, dass

$$q_\ell(\sigma_\ell^k) = v_\ell^k, \quad k \in K_\ell^2$$

$$q_\ell(\sigma_\ell^k) \approx v_\ell^k, \quad k \in K_\ell \setminus K_\ell^2$$

**3.** Computerimplementiertes Verfahren nach Anspruch 1 oder Anspruch 2, bei dem die implizite Darstellung $w$ so berechnet wird, dass $w(\gamma_j(u)) = 0$ für $j = 1, \ldots, L$ und $u \in [0, 1]$.

**4.** Computerimplementiertes Verfahren nach Anspruch 1 oder Anspruch 2, bei dem die implizite Darstellung $w_\ell$ so berechnet wird, dass $w_\ell(\gamma_j(u)) = 0$ für $j = 1, \ldots, l - 1, l + 1, \ldots, L$ und $u \in [0, 1]$.

**5.** Computerimplementiertes Verfahren nach einem der Ansprüche 1 bis 4, wobei die Berechnung der impliziten Darstellungen $w$ und $w_l$ wie folgt erfolgt:

a) mit $\Sigma_\ell := \{\sigma \in \Gamma : q_\ell(\sigma) \leq h_\ell\}$ den *Randstreifen* von $\gamma_\ell$ mit der Breite $h_\ell > 0$ bezeichnen, einen Wert $h_\ell > 0$ so festlegen, dass sich nur Randstreifen benachbarter Kurven schneiden, und dass dieser Schnittpunkt aus einem einzigen zusammenhängenden Stück besteht;

b) Ableitung eines neuen Splines $\bar{q}_\ell$ aus $q_\ell$ wie folgt:

*(i)* Klassifizierung der Indizes in der B-Spline-Darstellung $q_l = \sum^i q_l^i b_i$ gemäß

$$I_\ell := \{i : q_\ell(\sigma) = 0 \text{ für einige } \sigma \in \text{supp } b_i\}$$

$$J_\ell := \{i : q_\ell(\sigma) > h_\ell \text{ für einige } \sigma \in \text{supp } b_i\};$$

*(ii)* Wenn die Mengen $I_\ell$ und $J_\ell$ nicht disjunkt sind, verfeinern Sie die B-Spline-Darstellung von $q_\ell$ durch Einfügen von Knoten und wiederholen Sie den ersten Schritt.

*(iii)* Setzen Sie

$$\bar{q}_\ell^i := \begin{cases} q_\ell^i & \text{if } i \in I_\ell \\ h_\ell & \text{if } i \in J_\ell, \end{cases}$$

wobei Koeffizienten mit Indizes weder in $I_\ell$ noch in $J_\ell$ so berechnet werden, dass der resultierende Spline eine vernünftige Form hat, beispielsweise durch Minimierung eines Standard-Gerechtigkeitsfunktionals;

*(iv)* Berechnung der spline $\bar{q}_\ell := \sum_i \vec{q}_\ell^i b_i$ ;

c) unter Verwendung der gewünschten Multiplizität $r$ die implizite Repräsentation $w := (\bar{q}_1 \cdots \bar{q}L)^r$ der Randkurven $\gamma_1, \ldots, \gamma_L$ mit Plateau berechnen;

d) Man berechnet den Spline $q_\ell := \bar{q}_{\ell-1}\bar{q}_{\ell+1}$ und überschreibt damit seinen früheren Wert, und wendet auf ihn die in Schritt (b) beschriebene Methode an, setzt nun aber $\vec{q}_\ell^i := 0$ , wenn $i \in J_\ell$

e) unter Verwendung der gewünschten Multiplizität $r$, wobei die implizite Darstellung $\omega_\ell := \vec{q}_\ell^r$ mit Nullplateau berechnet wird;

**6.** Ein Computer, der für geometrische Modellierung, computergestütztes Design, Simulation und Visualisierung konfiguriert ist, mit Mitteln zum Erzeugen einer Oberflächendarstellung gemäß einem oder mehreren der vorangehenden Verfahrensansprüche.

## Revendications

**1.** Procédé mis en oeuvre par ordinateur pour générer une représentation de surface destinée à être traitée dans des imprimantes 3D ou des machines CNC, qui alloue de la mémoire pour stocker des tableaux de points de contrôle et de vecteurs de noeuds des surfaces splines bivariées.

$$\mathbf{b}, \mathbf{r}_1, \ldots, \mathbf{r}_L,$$

des fonctions spline bivariées

$$_1\kappa = [p_1, q_1],..., \kappa_L = [p_L, q_L],$$

définir les courbes d'ajustement $\gamma_\ell$ avec une représentation implicite $q_l$ et paramétrée par $p_\ell$, $\ell = 1, ... L$, d'une fonction spline bivariée $w$,
qui est une représentation implicite de toutes les courbes d'ajustement, et d'une fonction spline bivariée

$$w_1, ..., w_L,$$

où $w_\ell$ est une représentation implicite de toutes les courbes d'ajustement, mais $\gamma_\ell$, $\ell = 1,...,L$, et qui permet un calcul informatique d'un nouveau Surface de spline **a,** délimitée par la succession de courbes d'assiette $\gamma_\ell$, formant une boucle fermée, selon la formule

$$\mathbf{a} = \frac{w \cdot \mathbf{b} + \sum_{\ell=1}^{L} w_\ell \cdot \mathbf{r}_\ell \circ \kappa_\ell}{w + \sum_{\ell=1}^{L} w_\ell}$$

pour le traitement ultérieur, l'exportation, l'affichage ou l'échange par l'ordinateur, qui génère des données à partir de la nouvelle surface de spline **a** pour le traitement dans des imprimantes 3D ou des machines CNC.

**2.** Procédé mis en oeuvre par ordinateur selon la revendication 1, dans lequel la spline de définition $\kappa_\ell = [p_\ell, q_\ell]$ est calculée de telle sorte que la bande reparamétrée $r_\ell \circ \kappa_\ell$ approche la base **b** au voisinage de la courbe d'ajustement $\gamma_\ell$ par les étapes suivantes :

a) Définition des vecteurs de noeuds $S_\ell$, $T_\ell$ et des degrés de coordonnées $n_\ell$, $m_\ell$, pour les splines $p_\ell, q_\ell \in \mathbb{S}_0^1$ ;

b) le calcul des listes de paramètres $\sigma_\ell^k \in \mathbb{R}^2$ and $(u_\ell^k, v_\ell^k) \in \mathbb{R}^2$ , $k \in K_\ell$ de sorte que $\mathbf{b}(\sigma_\ell^k)$ soit

proche de $\mathbf{r}_\ell(u_\ell^k, v_\ell^k)$ de préférence projection orthogonale est appliquée.

c) Définition de sous-ensembles $K_\ell^1, K_\ell^2 \subset K_\ell$ d'indices pour l'interpolation points pour $p_\ell$ ou $q_\ell$;

d) à l'aide d'une méthode d'approximation, de préférence des moindres carrés restreints ou des splines de lissage, $p_\ell$ de manière à ce que

$$p_\ell(\sigma_\ell^k) = u_\ell^k, \quad k \in K_\ell^1$$

$$p_\ell(\sigma_\ell^k) \approx u_\ell^k, \quad k \in K_\ell \setminus K_\ell^1;$$

e) De manière analogue, on peut, à l'aide d'une méthode d'approximation $q_\ell$ de telle sorte que

$$q_\ell(\sigma_\ell^k) = v_\ell^k, \quad k \in K_\ell^2$$

$$q_\ell(\sigma_\ell^k) \approx v_\ell^k, \quad k \in K_\ell \setminus K_\ell^2$$

3. Procédé mis en oeuvre par ordinateur selon la revendication 1 ou la revendication 2, dans lequel la représentation implicite $w$ est calculée de telle sorte que $w(\gamma_j(u)) = 0$ pour $j = 1, \ldots, L$ et $u \in [0, 1]$.

4. Procédé mis en oeuvre par ordinateur selon la revendication 1 ou la revendication 2, dans lequel la représentation implicite $w_\ell$ est calculée de telle sorte que $w_\ell(\gamma_j(u)) = 0$ pour $j = 1, \ldots, l - 1, l + 1, \ldots, L$ et $u \in [0, 1]$.

5. Procédé mis en oeuvre par ordinateur selon l'une quelconque des revendications 1 à 4, dans lequel le calcul des représentations implicites $w$ et $w_l$ est effectué comme suit :

   a) avec $\Sigma_\ell := \{\sigma \in \Gamma : q_\ell(\sigma) \le h_\ell\}$ désigner la *bande marginale* de $\gamma_\ell$ de largeur $h_\ell > 0$, fixer une valeur $h_\ell > 0$ de telle sorte que seules les bandes marginales de courbes voisines se coupent, et que ce point d'intersection consiste en une seule pièce cohérente ;
   b) Dérivation d'une nouvelle spline $\overline{q}_\ell$ à partir de $\overline{q}_\ell$ comme suit :

   *(i)* Classification des indices dans la représentation B-spline $q_l = \sum^i q_l^i b_i$ conformément à

   $$I_\ell := \{i : q_\ell(\sigma) = 0 \text{ pour certains } \sigma \in \text{supp } b\}_i$$

   $$J_\ell := \{i : q_\ell(\sigma) > h_\ell \text{ pour certains } \sigma \in \text{supp } b_i\};$$

   *(ii)* Si les ensembles $I_\ell$ et $J_\ell$ ne sont pas disjoints, affinez la représentation B-spline de $q_\ell$ en insérant des noeuds et répétez la première étape.
   *(iii)* Définir

   $$\bar{q}_\ell^i := \begin{cases} q_\ell^i & \text{if } i \in I_\ell \\ h_\ell & \text{if } i \in J_\ell, \end{cases}$$

   où les coefficients avec des indices ne sont calculés ni dans $I_\ell$ ni dans $J_\ell$ de telle sorte que la spline résultante ait une forme raisonnable, par exemple en minimisant une valeur standard de fonction de justice ;

*(iv)* Calcul de la spline $\bar{q}_\ell := \sum_i \bar{q}_\ell^i b_i$ ;

c) en utilisant la multiplicité r souhaitée, la représentation implicite $\omega := (\bar{q}_1 \cdots \bar{q}_L)^r$ des courbes de bord $\gamma_1$, . . . , $\gamma_L$ avec plateau ;

d) On calcule la spline $q_\ell := (q_\ell - 1 \bar{q}_\ell + 1$ , en écrasant sa valeur précédente, et on lui applique la méthode décrite à l'étape (b), mais on fixe maintenant $\vec{q}_\ell^i := 0$ , si $i \in J_\ell$

e) en utilisant la multiplicité r souhaitée, la représentation implicite $\omega_\ell := \vec{q}_\ell^r$ étant calculée avec un plateau zéro ;

6. Un ordinateur configuré pour la modélisation géométrique, la conception assistée par ordinateur, la simulation et la visualisation, comprenant des moyens pour générer une représentation de surface selon une ou plusieurs des revendications de procédé précédentes.

Figure 1: Parametrizing spline

Figure 2: Implicit representation

Figure 3: Base **b** and ribbons $\mathbf{r}_\ell$

Figure 4: ABC-surface **a**

Figure 5: Base $\mathbf{b}$ and modified ribbons $\tilde{\mathbf{r}}_\ell$

Figure 6: Modified ABC-surface $\tilde{\mathbf{a}}$

Figure 7: Implicit representation $w$

Figure 8: Implicit representation $w_\ell$

Figure 9: Boundary stripes

Figure 10: Plateau generation

Figure 11: Implicit representation $w$ with plateau

Figure 12: Implicit representation $w_\ell$ with plateau

Figure 13: General level sets $\mu_\ell^i$

Figure 14: Straight level sets $\mu_\ell^i$

Figure 15: Partition of the domain $\Gamma$

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7274364 B2, Th.W. Sederberg

### Non-patent literature cited in the description

- **B. MARUSSIG ; T.J.R. HUGHES.** A Review of Trimming in Isogeometric Analysis: Challenges, Data Exchange and Simulation Aspects. *Archives of Computational Methods in Engineering,* 2018, vol. 25 (4), 1059-1127
- Subdivision surfaces. **J. PETERS ; U. REIF.** Series Geometry and Computing. Springer, 2008, vol. 3
- **T. VÁRADY ; P. SALVI ; G. KARIKÁ.** Enhancement of a multi-sided Bézier surface representation. *Computer Aided Geometric Design,* 2017, vol. 55 (69), 69-83
- **N. PLA-GARCIA ; M. VIGO-ANGLADA ; J. COTRINA-NAVAU.** N-sided patches with B-spline boundaries. *Computers and Graphics,* 2006, vol. 30 (6), 959-970
- Geometric continuity. **J. PETERS.** Handbook of Computer Aided Geometric Design. 2002, 193-227